Europäisches Patentamt

European Patent Office

Office europeen des brevets

(19)

(11) Veroffentlichungsnummer: **0 080 738**
**A2**

(12) # EUROPÄISCHE PATENTANMELDUNG

(21) Anmeldenummer: **82111175.4**

(22) Anmeldetag: **02.12.82**

(51) Int. Cl.³: **H 01 L 21/48**
**H 01 L 23/48**

(30) Priorität: **02.12.81 DE 3147729**

(43) Veröffentlichungstag der Anmeldung:
**08.06.83 Patentblatt 83 23**

(84) Benannte Vertragsstaaten:
**AT CH DE FR LI**

(71) Anmelder: **SIEMENS AKTIENGESELLSCHAFT**
**Berlin und München Wittelsbacherplatz 2**
**D-8000 München 2(DE)**

(72) Erfinder: **Brenner, Hermann**
**Kaiserstrasse 65**
**D-8000 München 40(DE)**

(72) Erfinder: **Hadersbeck, Hans**
**Pistorinistrasse 14**
**D-8000 München 90(DE)**

(54) **Zwischenträgerband mit Verdrahtungselementen zur Bestückung mit Chipbausteinen.**

(57) Ein kaschiertes Polyimidband wird nur auf der Seite der Kupferfolie im sogenannten "beadcoat"-Verfahren mit Fotolack beschichtet, die in den Ausstanzungen der Trägerfolie offene Unterseite der Kupferfolie mit einer schmelzfähigen Metallisierung versehen und anschließend in bekannter Weise mittels Foto-, Galvanisier- und Ätztechnik die gewünschte Strukturierung erzeugt. Von dem so fertiggestellten Trägerband wird ferner durch Erwärmung des Mittelbereiches unmittelbar vor der Kontaktierung die metallische Stabilisierung entfernt und bei der Kontaktierung das Schmelzmaterial zwischen den Beinchen aufgetrennt.

EP 0 080 738 A2

SIEMENS AKTIENGESELLSCHAFT
Berlin und München

Unser Zeichen
VPA 81 P 7184 E

Zwischenträgerband mit Verdrahtungselementen zur Bestückung mit Chipbausteinen.

Die Erfindung betrifft ein Verfahren zur Herstellung
eines Zwischenträgerbandes mit Verdrahtungselementen,
das automatisch mit Chipbausteinen (z. B. Halbleiterelementen) bestückt und kontaktiert werden kann und das aus
einem perforierten Kunststoffband besteht, auf dem auf
der einen Seite eine Kupferfolie aufgebracht ist.

Aus der DE-PS 24 14 297 ist bereits ein Verfahren zur
teilautomatischen Herstellung von Zwischenträgern für
Halbleiterbauelemente bekannt. Dabei wird z. B. von einem
Polyimidfilm ausgegangen, der mit einer Kunststoffkleberschicht versehen ist. In diesen Film wird eine
Perforation eingebracht und außerdem Zusatzlöcher ausgestanzt. Auf den so vorbereiteten Film wird eine Kupferfolie auflaminiert und anschließend der Film beidseitig
mit Fotolack beschichtet. Mittels Fotomasken und Fototechnik werden kupferseitig auf dem Film Feinstrukturen
aufgebracht. In diesen Feinstrukturen wird galvanisch
Zinn abgeschieden. Anschließend wird der Fotolack kupferseitig entfernt und das Kupfer bis auf die verzinnten
Kupferbahnen der Feinstrukturen weggeätzt. Nach Entfernen des Fotolacks auf der Rückseite des Films erhält
man den gewünschten Zwischenträger.

Die beidseitige Beschichtung erfordert eine relativ große
Menge des teueren Fotolackes. Außerdem bedingen die Ausnehmungen in der Polyimidfolie stark unterschiedliche
Schichtdicken des Fotolackes, wodurch die Erzeugung einer
gleichbleibend einwandfreien Fotolackabdeckung für die

nachfolgende galvanische Metallisierung erschwert wird. Nach dem Ätzen sind die freistehenden Anschlußbeinchen gefährdet und können bei der Handhabung des Zwischenträgerbandes verbogen werden.

Der Erfindung liegt die Aufgabe zugrunde, das eingangs definierte Verfahren zu realisieren. Das Zwischenträgerband soll so gestaltet sein, daß eine dynamische Prüfung der Chipbausteine (z. B. Halbleiterelemente) möglich ist. Darüber hinaus soll das Verfahren nach der Erfindung zur Herstellung des Zwischenträgerbandes einfach, gut reproduzierbar und kostengünstig sein.

Diese Aufgabe wird erfindungsgemäß dadurch gelöst, daß das Zwischenträgerband auf der Seite der Kupferfolie mit Fotolack beschichtet und die in den Ausstanzungen der Trägerfolie offene Unterseite der Kupferfolie mit einer schmelzfähigen Metallisierung versehen wird und anschließend in bekannter Weise mittels Foto-, Galvanisier- und Ätztechnik die gewünschte Strukturierung erzeugt wird und daß von dem so fertiggestellten Zwischenträgerband ferner durch Erwärmung des Mittelbereiches unmittelbar vor der Kontaktierung die metallische Stabilisierung entfernt und bei der Kontaktierung das Schmelzmaterial zwischen den Beinchen aufgetrennt wird.

Das kaschierte Zwischenträgerband, z. B. Polyimidband, wird nur auf der Seite der Kupferfolie im sogenannten "beadcoat"-Verfahren mit Fotolack beschichtet. Der Verbrauch an Fotolack wird damit erheblich reduziert. Außerdem gewinnt man mit der einseitigen Beschichtung auf Kupferfolie einheitliche Verhältnisse für die Trocknung, Belichtung und Entwicklung des Fotolacks. Damit ist eine wesentliche Voraussetzung für eine sichere und gute Reproduzierbarkeit des Verfahrens gegeben.

Die in den Ausstanzungen der Foli... ...ffene Unter-

seite der Kupferfolie erhält bei der galvanischen Metallisierung den gleichen Ätzresist wie die Verdrahtungsstruktur auf der Oberseite. Gleichzeitig und als Hauptzweck wird mit der auf der Unterseite der Kupferfolie abgeschiedenen ätzresistenten Metallschicht eine mechanische Stabilisierung der Anschlußbeinchen erreicht. Nach dem Ätzen werden die schmalen Trennfugen zwischen den einzelnen Anschlußbeinchen sowie zwischen den Anschlußbeinchen und dem Innenbereich durch diese Metallschicht überbrückt. Damit werden die Anschlußbeinchen in ihrer genauen Lage bis zur Kontaktierung festgehalten. Unmittelbar vor der Kontaktierung wird allein der Innenbereich z. B. mit einem Heizstempel erwärmt. Das den Innenbereich füllende Kupferteil wird dadurch lose und kann weggenommen werden. Die noch verbleibenden Überbrückungen zwischen den Anschlußbeinchen werden beim Kontaktieren geschmolzen und aufgetrennt.

1 Patentanspruch

Patentanspruch.

1. Verfahren zur Herstellung eines Zwischenträgerbandes mit Verdrahtungselementen, das automatisch mit Chipbausteinen (z. B. Halbleiterelementen) bestückt und kontaktiert werden kann und das aus einem perforierten Kunststoffband besteht, auf dem auf der einen Seite eine Kupferfolie aufgebracht ist, **d a d u r c h   g e - k e n n z e i c h n e t ,** daß dieses Band auf der Seite der Kupferfolie mit Fotolack beschichtet und die in den Ausstanzungen der Trägerfolie offene Unterseite der Kupferfolie mit einer schmelzfähigen Metallisierung versehen wird und anschließend in bekannter Weise mittels Foto-, Galvanisier- und Ätztechnik die gewünschte Strukturierung erzeugt wird und daß von dem so fertiggestellten Zwischenträgerband ferner durch Erwärmung des Mittelbereiches unmittelbar vor der Kontaktierung die metallische Stabilisierung entfernt und bei der Kontaktierung das Schmelzmaterial zwischen den Beinchen aufgetrennt wird.